# EUROPEAN PATENT APPLICATION

(11) **EP 3 821 969 A1**
(43) Date of publication of application: **19.05.2021**
(21) Application number: 19833894.9
(22) Date of filing: 11.07.2019
(51) Int. Cl.: B01D 53/32, H01J 37/32

(54) **METHOD AND APPARATUS FOR TREATING DISCHARGE GAS CONTAINING TARGET GAS IN PLASMA STATE**

(30) Priority: 13.07.2018 KR 20180081616
(71) Applicant: Plasnix, Incheon 21638 (KR)
(72) Inventor: PAEK, Kwang Hyun, Incheon 21632 (KR); JU, Wontae, Seoul 06218 (KR); JANG, Yun Sang, Incheon 21648 (KR)
(74) Representative: Danubia Patent & Law Office LLC
(86) International application number: PCT/KR2019/008569
(87) International publication number: WO 2020/013630

(57) **Abstract**

The present disclosure provides a method for converting the target gas contained in the exhaust gas in plasma phase and an apparatus for implementing the method, the method comprising the steps of: generating a plasma in a conversion region in which the conversion of the target gas occurs; supplying, to the conversion region, a conversion promoting agent containing a conversion promoting element of which the first ionization energy is not greater than 10eV for promoting the conversion of the target gas; supplying, to the conversion region, a conversion agent that produces conversion products by combining with the dissociation products of the target gas and prevents the dissociation products from recombining into the target gas; and supplying the exhaust gas containing the target gas to the conversion region.

According to the present disclosure, it is possible to increase the conversion of the target gas and reduce the energy required for the conversion process. Furthermore, this contributes to reducing the maintenance cost of the conversion apparatus, extending its service life, and making it easier to implement large-capacity conversion apparatus. The present disclosure can be applied not only to the process of removing harmful substances, but also to the process of synthesizing useful substances, such as reforming, gasification, gas to liquid, polymerization, etc.

## Description

### TECHNICAL FIELD

The present disclosure relates to a method and an apparatus for converting the target gas contained in the exhaust gas in plasma phase, and more particularly to a method and an apparatus for increasing the conversion of the target gas contained in the exhaust gas and reducing energy required in such a process.

### BACKGROUND

Currently, various types of harmful gases are exhausted in the manufacturing process of various industrial fields. In particular, emissions from manufacturing processes such as semiconductors, flat panel displays, light-emitting diodes, and solar cells contain a large amount of gases harmful to the human body and the environment, including greenhouse gases, ozone depleting gases, toxic gases, explosive gases, and pyrophoric gases. These harmful gases should be converted to other substances to reduce emissions to the atmosphere. Among the gases to be converted(hereinafter, target gas), perfluorocompounds such as CF₄, C₂F₆, C₃F₈, and SF₆, NF₃ are typical greenhouse gases used for etching, chemical vapor deposition or cleaning the chambers used in these processes. Among them, perfluorocompounds and SF6, in particular, are difficult to convert due to their high bond dissociation energies between the constituent atoms. Currently, methods such as electric heater, combustion, catalyst, and thermal plasma are commercialized for the conversion of the target gas contained in the exhaust gas in these processes.

Electric heater has the advantage of being able to convert the target gas contained in the exhaust gas simply, but it consumes a lot of energy and temperature of the heater is limited to 1300 °C or less, making it difficult to convert target gas such as perfluorocompounds. Combustion method using a high-temperature flame generated by a chemical reaction between fuel such as LNG and LPG and an oxidizing agent such as oxygen is advantageous because it can obtain a higher temperature than the electric heater method, but it has problems of high fuel usage, high cost and hassle in installing and operating fuel-related utilities, and production of large amounts of nitrogen oxides. Furthermore, changing the supply conditions, such as flow rates and compositions, of the exhaust gas may make conversion process unstable and even extinguish the flames. Although using solid-phase catalysts allows the target gas contained in the exhaust gas to be converted at a relatively low temperature and consequently with lower energy consumption, frequent replacement due to catalyst poisoning or deterioration hinders continuous operation and increases maintenance costs. Thermal plasma method, which forms a plasma of tens of thousands °C, has recently been used in the conversion of the target gas that is difficult to convert, such as CF₄. This method regulates the conversion environment by external power, so stable operation is possible even if the supply conditions of the exhaust gas change. However, conventional thermal plasma method consumes a lot of electricity to generate high temperature plasma which is required for high conversion of the target gas. In many cases, the target gas is exhausted mixed and diluted with a large amount of nitrogen, air, and the like. Since the flow rate of the dilution gas is often very large, ranging from hundreds to thousands of slpm(standard liter per minute), higher power operation is needed for the conversion of the target gas contained in the exhaust gas. High power operation of thermal plasma generating device also shortens the service life of components, e.g., electrodes, thereby increasing the number of shutdowns and maintenance costs.

### SUMMARY

In view of the above, the present disclosure aims to address the aforementioned problems to increase the conversion of the target gas contained in the exhaust gas and reduce energy required in the conversion process. Another aim of the present disclosure is to reduce the maintenance costs of the conversion apparatus, extend its service life and implement a conversion apparatus of large capacity more readily.

Electrons interact with gas molecules in various ways, and the dissociation of gas molecules by electron impact is one of these interactions. The initial step in gas conversion is a dissociation process in which a gas molecule is separated into smaller particles such as atoms, ions, and reactive species, and electrons can play an important role in this dissociation process. Electrons are generated when neutral particles in atomic or molecular state are ionized. According to the Saha equation, electron density in air at atmospheric pressure and room temperature is very low, about 10⁻¹²² compared to the density of neutral particles, and the electron density increases as the temperature of the gas increases.

Plasma, defined as "a quasi-neutral gas composed of charged particles and neutral particles" contains electrons abundantly. Plasmas are classified into non-equilibrium plasmas and local thermodynamic equilibrium plasmas depending on the state of thermal equilibrium of their constituent particles. Non-equilibrium plasmas, in which the temperature of the heavy particles such as ions and neutral particles is much lower than the electron temperature, are also referred to as low-temperature plasmas and typically generated through glow discharges, dielectric barrier discharges, or corona discharges. Local thermodynamic equilibrium plasmas, in which the temperature of the heavy particles does not differ significantly from the electron temperature, are also referred to as thermal plasmas and typically generated through arc discharges and high frequency thermal discharges. Plasmas generated through gliding arc discharges or microwave discharges are considered to be in the middle between the aforementioned two types of plasmas. In addition to the above plasmas produced by the effect of the electromagnetic field, combustion flames or heated gases containing a significant amount of charged particles can also be regarded as plasmas in a broad sense.

The energy required to separate an electron from a neutral atom or molecule is referred to as ionization energy, and the first ionization energy is the energy required to separate the most loosely held electron from the neutral particle. Ionization energy is affected by the size of an atom or molecule and the configuration of electrons, and an atom or molecule with lower ionization energy can generate electrons more easily. Plasmas are generally produced from gaseous substances such as inert gases, nitrogen, oxygen, hydrogen or water vapor, but their first ionization energy is relatively high, over 10eV. Although it is known that adding substances of lower ionization energy to the aforementioned plasmas increases electron density and changes electron temperature, this concept has been used only for limited studies, such as magnetohydrodynamic power generation for the purpose of increasing the electrical conductivity of plasma. Elements with low first ionization energy include alkali metals such as lithium, sodium, potassium, rubidium, and cesium, alkaline earth metals such as beryllium, magnesium, calcium, strontium, and barium, transition metals such as iron, nickel, and copper, and aluminum.

The present disclosure is based on the aforementioned two ideas of 1) Electrons play an important role in the initial stage of gas conversion, and 2) Adding elements with low first ionization energy to the plasma increases electron density, or even electron temperature.

The study for the present disclosure shows that adding elements of which the first ionization energy is not greater than 10eV (hereinafter, conversion promoting elements) to the plasma significantly increases the conversion of the target gas. Especially it has been shown that conversion promoting elements can work repeatedly and continuously even with small quantities if the plasma also contains substances that produce conversion products by combining with the dissociation products of the target gas and prevent the dissociation products from recombining into the target gas (hereinafter, conversion agents). Water, hydrogen, oxygen, hydrocarbons, and the like can be used as the conversion agents.

It is expected that the conversion increases because the conversion promoting element accelerates the dissociation of the target gas by increasing electron density or temperature and thereby facilitates the overall conversion, not because the conversion promoting element combines chemically with the dissociation products of target gas directly. Catalysis is to increase the speed of a specific reaction by adding an additional substance called a catalyst. The catalyst does not participate directly in the reaction, so it can act repeatedly and continuously without conversion or consumption. It was shown that the conversion promoting element in the present disclosure serves as a kind of catalyst in plasma phase.

The study for the present disclosure shows that the lower the first ionization energy of the conversion promoting element, the higher the conversion of the target gas. Alkali metal elements and alkaline earth metal elements are especially suitable as conversion promoting elements due to their low first ionization energy. Of course, it is allowed to use different types of conversion promoting elements together. It was shown that the conversion of the target gas is also greatly affected by the mole fraction of the conversion promoting elements in the region where the conversion of the target gas occurs (hereinafter, the conversion region), and the mole fraction of the conversion promoting elements of 0.1 to 10,000 ppm is preferable. Below 0.1 ppm, conversion increase is insignificant, and above 10,000 ppm, while large amounts of conversion promoting elements are needed, the conversion does not increase significantly compared to the case at a lower mole fraction. A more preferred mole fraction of the conversion promoting element ranges between 1 and 1,000 ppm.

It is preferable to supply the conversion agent in an amount more than that required by the stoichiometry of the reaction between the target gas and the conversion agent because the conversion agent has to combine chemically with the dissociation products of the target gas and convert it to the conversion products. When the conversion agent is insufficient and the conversion promoting element can combine chemically with the dissociation products of the target gas, a part of the conversion promoting element plays the role of the conversion agent, thereby inhibiting the role of the catalyst. When the conversion agent is insufficient and the conversion promoting element cannot combine chemically with the dissociation products of the target gas, recombination of the dissociation products to the target gas increases.

In the conventional methods, reducing the energy input such as electricity in plasma generating device or fuels in combustion burner lowers the conversion of the target gas. On the other hand, in the present disclosure, it is possible to keep the conversion of the target gas high even at a lower energy input and thus at a lower temperature. To be brief, the temperature required for conversion can be lowered because of the catalytic action of the conversion promoting element.

It was shown that the present disclosure is applicable not only in a plasma generated by electric and/or magnetic fields, but also in a combustion flame or a gas heated by an electric heater, or in a mixed atmosphere thereof. The plasma described in the present disclosure refers to the plasma in such a broad sense.

According to the present disclosure, it is possible to increase the conversion of the target gas contained in the exhaust gas and reduce the energy required for the conversion process. Furthermore, this contributes to reducing the maintenance cost of the conversion apparatus, extending its service life, and making it easier to implement large-capacity conversion apparatus. The present disclosure can be applied not only to the process of removing harmful substances, but also to the process of synthesizing useful substances, such as reforming, gasification, gas to liquid, polymerization, etc.

### BRIEF DESCRIPTION OF THE DRAWINGS

- FIG. 1: shows the concept of an apparatus for converting the target gas contained in the exhaust gas in plasma phase in accordance with an embodiment of the present disclosure;
- FIG. 1a: shows the concept of a conventional atomizer, and FIG. 1b shows the concept of an atomizer in accordance with an embodiment of the present disclosure;
- FIG. 2: shows the concept of an apparatus for converting the target gas contained in the exhaust gas in plasma phase in accordance with an embodiment of the present disclosure;
- FIG. 3: shows the concept of an apparatus for converting the target gas contained in the exhaust gas in plasma phase in accordance with an embodiment of the present disclosure;
- FIG. 4: shows the concept of an apparatus for converting the target gas contained in the exhaust gas in plasma phase in accordance with an embodiment of the present disclosure;
- FIG. 5: shows the conversions of CF₄ depending on the first ionization energy of the conversion promoting element;
- FIG. 6: shows the conversions of CF₄ depending on the mole fraction of the conversion promoting element, potassium;
- FIG. 7: shows the conversions of CF₄ depending on the presence of the conversion agent, water;
- FIG. 8: shows the conversions of CF₄ depending on the excess ratio of the conversion agent, water; and
- FIG. 9: shows the conversions of CF₄ depending on the presence of the conversion promoting element and T_{MIX}.

### DETAILED DESCRIPTION

Hereinafter, the embodiments of the present disclosure will be described in detail with reference to the accompanying drawings. The advantages and features of exemplary embodiments of the present disclosure and methods of accomplishing them will be clearly understood from the following description of the embodiments taken in conjunction with the accompanying drawings. However, the present disclosure is not limited to those embodiments and may be implemented in various forms. It should be noted that the embodiments are provided to make a full disclosure and also to allow those skilled in the art to know the full scope of the present disclosure. Therefore, the present disclosure will be defined only by the scope of the appended claims.

The action of the present disclosure will be described in detail hereinbelow with an example of CF₄ which is a typical target gas hard to convert because of the highest level of bond dissociation energy (CF₃-F, 5.7eV). The action of the present disclosure is not limited just to CF₄ but is also applicable to other target gases. In the embodiments, the conversions of several target gases other than CF4 are also described.

Some exemplary reactions of dissociation, recombination and conversion of dissociation products in CF₄ are described below. The entire conversion reaction of CF₄ using water as a conversion agent is also described in equation (1). The initial stage of CF₄ conversion is a dissociation process, and electrons are expected to play a key role in the process of dissociating CF₄ molecules into CFᵢ (i=1,2,3) species and fluorine atoms, molecules or ions. The conversion promoting element is expected to accelerate the dissociation of CF₄ molecules by increasing the density of electrons, thereby promoting the entire conversion reaction. When conversion agents such as water, hydrogen, oxygen, and hydrocarbons are added, they or their constituents combine with the dissociation products of CF4, inhibit their recombination to CF₄ and convert them into stable conversion products such as HF, COF₂, and CO₂. Various types of conversion agents can be used depending on the target gas and the conversion products to be obtained, and a material containing elements such as hydrogen, oxygen, nitrogen, carbon, etc. can be used as the conversion agent.

### Dissociation

CF₄ + e → CF₃ + F + e
CF₃ + e → CF₂ + F + e
CF₂ + e → CF + F + e
CF₄ + e → CF₂ + 2F + e
CF₄ + e → CF + F + F₂ + e CF₄ + e → CF₃ + F⁻
CF₄ + e → CF₃⁺ + F + 2e

### Recombination

CF₃ + F → CF₄
CF₃ + F⁻ → CF₄ + e
CF₃ + F₂ → CF₄ + F

### Conversion of dissociation products

CF₃ + H → CF₂ + HF
CF₃ + O → COF₂ + F
CF₃ + OH → COF₂ + HF
CF₂ + H → CF + HF
CF₂ + O → CO + 2F
CF₂ + O → COF + F
CF₂ + O₂ → COF₂ + O → CO₂ + F₂
CF₂ + OH → COF + HF
CF + H → C + HF
CF + O → CO + F
F + H₂ → HF + H
C + O₂ → CO₂

### Entire conversion reaction

CF₄ + 2H₂O = 4HF + CO₂ (1)

Table 1 illustrates an exemplary conversion conditions and results including feed rates, mole fractions in the conversion region, temperatures, conversion, and input power. It shows that although the mole fraction of potassium, a conversion promoting element, is very low at 100 ppm, it is possible to convert most of the CF₄ at low temperatures and power.

**Table 1**

| Item | | Exhaust gas | | Plasma forming gas | Conversion agent | Conversion promoting element (Conversion promoting agent) |
|---|---|---|---|---|---|---|
| | | Target gas | Dilution gas | | | |
| Constituents | | CF₄ | N₂ | N₂ | H₂O | K (KOH) |
| Feed Rate | slpm | 0.5 | 150 | 15 | - | - |
| | g/min | - | - | - | 0.97 | 0.029 (0.042) |
| | mol/min | 0.022 | 6.7 | 0.67 | 0.054 | 0.00075 (0.00075) |
| Mole fraction | | 3,000 | Balance | | 7,230 | 100 (100) |
| Mole ratio | K/CF₄ | 0.03 | | | | |
| | H₂O/CF₄ | 2.4 | | | | |
| Excess ratio | K | 0.008 | | | | |
| | H₂O | 1.2 | | | | |
| T_{A}(°C) | | 880 | | | | |
| T_{MIX}(°C) | | 1,590 | | | | |
| Conversion (%) | | 99.6 | | | | |
| Input Power(kW) | | 4.4 | | | | |

The conversion promoting elements that exist in the metallic state are mostly explosive or expensive, making it difficult to use them directly. The study for the present disclosure shows that any material containing the conversion promoting elements as constituents, for example, compounds, alloys, intermetallic compounds, or minerals can be used as a feedstock of the conversion promoting element (hereinafter, conversion promoting agent) to implement the features of the present disclosure, which is expected to be due to the decomposition of the conversion promoting agent into conversion promoting elements and others in the conversion region. Examples of compounds that can be used as conversion promoting agents include, but are not limited to, hydroxide, nitrate, nitrite, carbonate, hydrogen carbonate, percarbonate, acetate, formate, fluoride, chloride, chlorate, chlorite, hypochlorite, bromide, borohydride, phosphate, phosphite, hypophosphite, phthalate, sulfate, sulfide, dithionite, sulfamate, oxalate, oxide, isopropoxide. Examples of minerals that can be used as conversion promoting agents include, but are not limited to, feldspar, mica, muscovite, cryolite. While these conversion promoting agents also contain H, O and the like that can combine chemically with the dissociation products of the target gas, the effect is not significant because the amount thereof is very small in comparison with the conversion agent supplied separately, when a small amount of conversion promoting agent is used.

The mole fraction, expressed in ppm or parts per million, is the number of molecules of a concerned constituent among the total number of molecules of all constituents consisting of the target gas, the dilution gas, the plasma forming gas, the conversion agent and the conversion promoting agent. For convenience and clarity, in the present disclosure, the mole fraction is calculated using the state before dissociation of each constituent in the high-temperature conversion region. For example, 1 mole of CF₄ can be increased to a maximum of 5 moles by dissociation, but 1 mole is applied when calculating the mole fraction. The mole fraction of the conversion promoting element is calculated by multiplying the mole fraction of the conversion promoting agent by the number of conversion promoting elements contained in a conversion promoting agent molecule. For example, where the mole fraction of the conversion promoting agent, K₂CO₃, is 100 ppm, the mole fraction of the conversion promoting element, potassium, is 200 ppm.

Excess ratio of the conversion promoting element and the conversion agent is defined as a ratio of the mole number actually supplied to the conversion region to the mole number required by stoichiometry in the reaction of converting the target gas by the conversion promoting element or the conversion agent. Potassium may also act as a conversion agent as shown in equation (2) below and combine directly with the dissociation products of CF₄ to form KF. However, in such a case, a large amount of potassium is required, which is not economical, and a large amount of solid phase conversion product, KF, makes stable operation of the conversion apparatus difficult. In Table 1, the excess ratio of 0.008 means that only about 1/130 of the amount of potassium required by the stoichiometry of equation (2) is required.

CF₄ + 4K = 4KF + C (2)

The excess ratio of 1.2 means that 20% more water is supplied than the amount required by the stoichiometry of equation (1). In order for the conversion promoting element to play the role of conversion promotion, it is preferable that a sufficient amount of conversion agent must be chemically combined with the dissociation products of the target gas.

In order to further reduce energy consumption, it is preferable to recover waste heat remaining in the material after passing through the conversion region with a heat exchanger, and preheat the exhaust gas containing the target gas with this heat before supplying it to the conversion region. Adding materials of high thermal conductivity, for example, hydrogen or helium, to the exhaust gas containing the target gas and insulating the outer surface of the conversion apparatus are also preferred for efficient heat exchange and reducing energy consumption.

T_{A}, which is the measured value, is the temperature of the exhaust gas containing the target gas just before being supplied into the conversion region. T_{MIX}, average temperature of the conversion region, was calculated by assuming that the exhaust gas containing the target gas was uniformly mixed with high temperature plasma jet in an adiabatic state. The higher the T_{A}, that is, the more the preheating, the higher the T_{MIX} under the fixed input power. The study for the present disclosure shows that the higher the T_{MIX}, the greater the conversion enhancement by the conversion promoting element.

Conversion is defined as a ratio of a mole number of the converted target gas to the mole number of the target gas before conversion, and measured by means of gas chromatography or Fourier-transform infrared spectroscopy. The input power refers to the power supplied to the DC thermal plasma torch.

Table 1 illustrates KOH as a conversion promoting agent, but almost the same conversion can also be obtained if KF is used instead. From this, it can be seen that potassium serves as a kind of catalyst, not as a conversion agent as in equation (2).

A solution in which a solid-phase conversion promoting agent is dissolved in a liquid-phase material can be used as a feedstock of the conversion promoting element. If the liquid-phase material is a conversion agent, it is convenient to supply the conversion promoting element and the conversion agent together. Since many solid-phase conversion promoting agents show high solubility in the liquid-phase materials that can be used as a conversion agent, for example, water, alcohol and the like, it is easy to control the feed rate of the conversion promoting element and the conversion agent by adjusting the concentration and feed rate of the solution.

If the conversion promoting agent or the conversion agent is in solid or liquid phase, a step of vaporizing them is required. Exemplary methods include supplying them directly to the conversion region and vaporizing them with the heat in the region; vaporizing them with the heat in other regions in the conversion apparatus and then transferring them to the conversion region; and vaporizing them by using external heat source and then transferring them to the conversion region. The method for supplying them directly to the conversion region is the simplest way, but vaporization may be insufficient or the temperature of the conversion region may be lowered. In the case of the second method, heat can be used more efficiently, but loss due to wall adhesion may occur depending on the type of conversion promoting agent or the conversion agent during transport. Water, hydrogen, oxygen or hydrocarbons can act as a conversion agent by themselves, but hydrogen atom, oxygen atom, hydroxyl radical or their ion may combine with the dissociation products of target gas more easily. Thus it is advantageous to supply the conversion agent to the conversion region after passing it through a high-temperature region in the plasma generating means to enable both vaporization and this kind of activation. Supplying the conversion promoting agent to the conversion region through this method is also advantageous because the ionization of the conversion promoting element can be further increased. To this end, the conversion agent and/or the conversion promoting agent can be used as a feedstock or mixed with the existing feedstock e.g., plasma forming gases in thermal plasma torches, fuel/oxidants in the combustion burners. Steam plasma torches and LPG/LNG burners are examples of using this method to activate the conversion agents.

If the conversion promoting agent or conversion agent is aerosolized into fine droplets or powders, the specific surface area increases to facilitate vaporization and activation. An atomizer or a powder disperser can be used for this purpose. It is preferable that the conversion agent is homogeneously present around the target gas, and for this purpose, it may be mixed in advance with the exhaust gas containing the target gas and then transferred to the conversion region.

The feed rate of the conversion promoting agent and the conversion agent can be controlled by quantitative feeding devices such as mass flow meters, liquid pumps, powder feeders, etc. If these substances are liquid or solid, the feed rate can also be controlled by adjusting their temperature, that is, the vapor pressure and the flow rate of the carrier gas. Due to the characteristics of the present disclosure, the conversion promoting agent consumes very little, so the amount that can be used for a long time can be precharged in a certain space inside or outside the conversion apparatus and supplied by the latter method. It is more convenient if the conversion promoting agent is charged in a high-temperature part inside the conversion apparatus because it does not require a separate heat source.

The present disclosure will be described more specifically hereinbelow on the basis of the embodiments, but is not limited thereto.

### EMBODIMENT

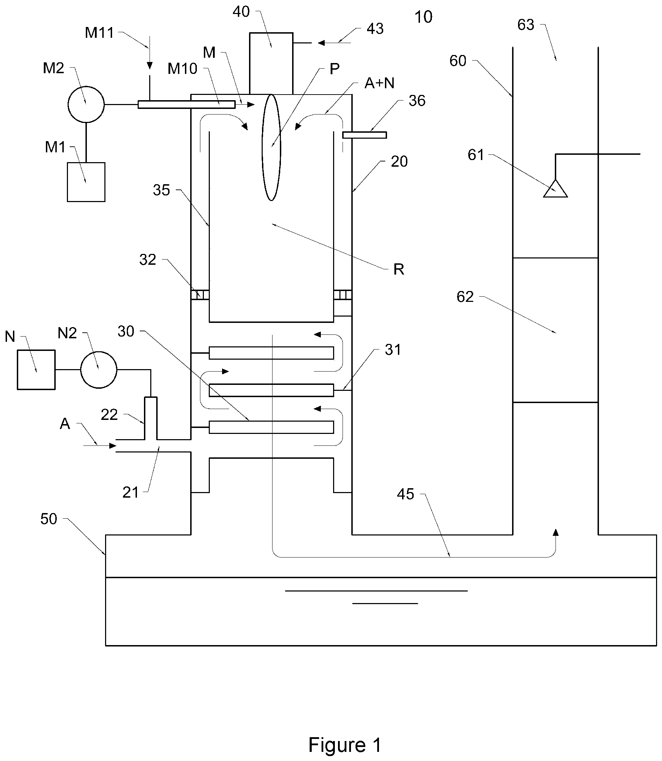

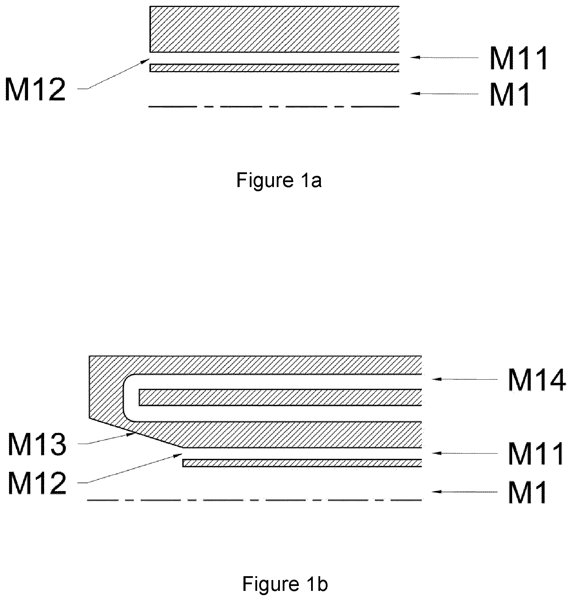

FIG. 1 shows the concept of an apparatus for converting the target gas contained in the exhaust gas in plasma phase in accordance with an embodiment of the present disclosure. The conversion apparatus 10 comprises a body 20, a DC thermal plasma torch 40, a heat exchanger 30, a guide 35, a water tank 50, a wet scrubber 60, and an atomizer M10. The outer surface of the body 20 is insulated from the ambient.

The exhaust gas containing the target gas A is introduced through a feed port 21. The conversion agent N of which the feed rate is controlled by a quantitative feeding device N2 is introduced through a feed port 22 and mixed with the exhaust gas containing the target gas A and the mixture is preheated by recovering the waste heat remaining in the material after passing through the conversion region 45 in the heat exchanger 30 of 4 stages in series. Thereafter, the mixture is swirled by the swirling flow generating mechanism 32, passes through the guide 35, further preheated, and then supplied to the conversion region R. A thermocouple 36 is installed at the end of the guide 35 for measuring the temperature of the mixture preheated, T_{A}.

The DC thermal plasma torch 40, installed on top of the conversion region R generates a high-temperature arc discharge in the nitrogen supplied as a plasma forming gas 43, between the cathode and the anode inside the torch using a direct current power supply, and then ejects the plasma into the conversion region R in the form of a jet P.

Conversion promoting agent M1 dissolved in water is supplied to the atomizer M10 installed on the side of exit of the DC thermal plasma torch 40 through a quantitative feeding device M2, for example, a syringe pump or peristaltic pump. The conversion promoting agent M1 in the aqueous solution state is aerosolized into fine droplets by nitrogen, which is the atomizing gas M11, in a fine gap M12 of the atomizer M10, and then vaporized and ionized by heat in the conversion region R. Using a conventional atomizer as shown in FIG. 1a often results in the clogging caused by solid-phase materials accumulated at the exit of the atomizer during long periods of operation. The study for the present disclosure shows that the clogging is significantly reduced by separating the gap M12 from the external flow by separating part M13 with inclined surface and cooling the outside of the atomizer with coolant M14, such as water, as shown in FIG. 1b.

The feed rate of the conversion promoting agent M1 and the mole fraction of the conversion promoting element M in the conversion region R can be controlled by adjusting the feed rate of the solution by the quantitative feeding device M2 and the concentration of the conversion promoting agent M1 in the solution.

The total feed rate of the conversion agent N is determined by the sum of the quantity supplied to the feed port 22 and the atomizer M10.

The target gas contained in the exhaust gas is converted by the action of the plasma jet P, the conversion promoting element M and the conversion agent N in the conversion region R. The material after passing through the conversion region 45 is cooled after preheating the mixture of the exhaust gas containing the target gas A and the conversion agent N by means of the heat exchanger 30, passes through the water tank 50 and the wet scrubber 60 to remove the products from conversion, for example, HF and KF, and is discharged through an exhaust port 63.

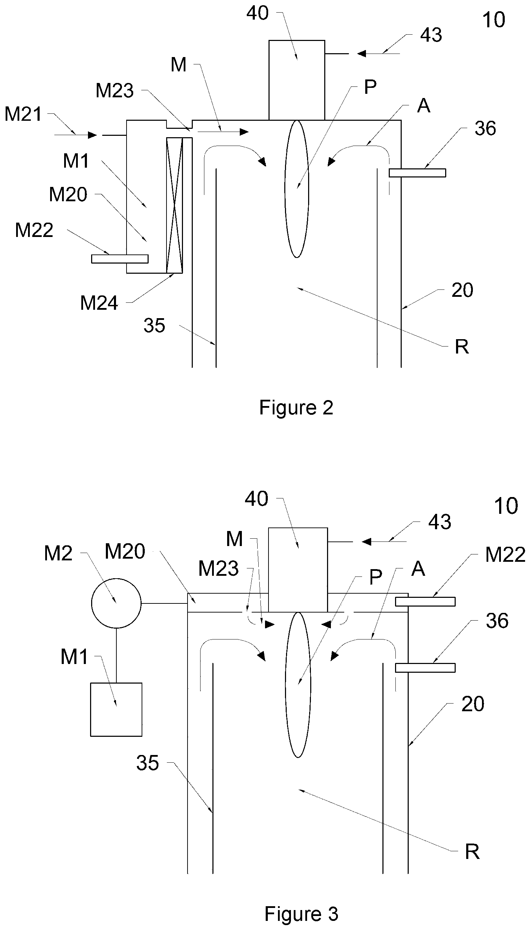

FIG. 2 shows the concept of an apparatus for converting the target gas contained in the exhaust gas in plasma phase in accordance with an embodiment of the present disclosure. Potassium metal, as a conversion promoting agent M1, is precharged into the vaporization part M20 located outside the body 20. Potassium is vaporized by external vaporizing heat source M24 which controls the temperature of the potassium by thermocouple M22, then transferred to the conversion region R using nitrogen as carrier gas M21 through the feed port M23. Other than that, it is the same as FIG. 1.

FIG. 3 shows the concept of an apparatus for converting the target gas contained in the exhaust gas in plasma phase in accordance with an embodiment of the present disclosure. An aqueous solution obtained by dissolving KNO3, as a conversion promoting agent M1, in water is supplied to the vaporization part M20 located around the conversion region R through a quantitative feeding device M2. The solution is vaporized with heat around the conversion region R and then supplied to the conversion region R through the feed port M23. Other than that, it is the same as FIG. 1.

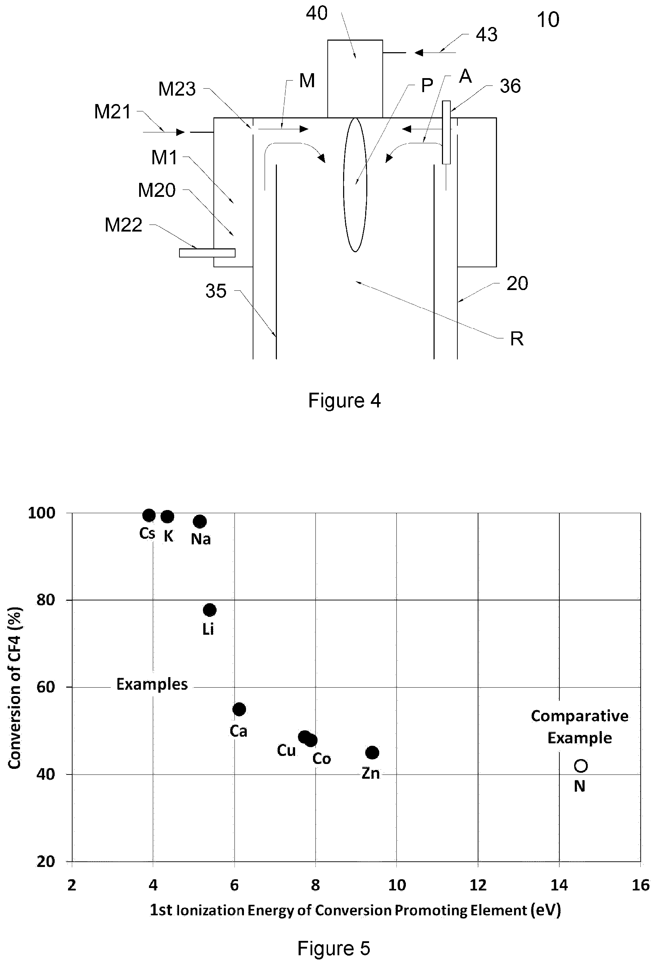

FIG. 4 shows the concept of an apparatus for converting the target gas contained in the exhaust gas in plasma phase in accordance with an embodiment of the present disclosure. KNO3, as a conversion promoting agent M1, is precharged into the vaporization part M20 located around the conversion region R. KNO3 is vaporized with heat around the conversion region R while monitoring the temperature of KNO3 by thermocouple M22 and then transferred to the conversion region R using nitrogen as carrier gas M21 through the feed port M23. Other than that, it is the same as FIG. 1.

Tables 2 to 6 illustrate the conditions and the results of conversion in the conversion apparatus using DC thermal plasma torch, combustion burner, gliding arc generator and electric heater.

**Table 2**

| | FIG | Plasma generating means | Exhaust gas | | Conversion promoting agent | Conversion promoting element | 1st ionization energy (eV) | Conversion agent | Dilution gas flow rate (slpm) | Mole fraction (ppm) | | | Excess ratio | | T_{A} (°C) | T_{MIX} (°C) | Conversion (%) | Input Power (kW) |
|---|---|---|---|---|---|---|---|---|---|---|---|---|---|---|---|---|---|---|
| | | | Target gas | Dilutio n gas | | | | | | Target gas | Conversio n promoting element | Conversio n agent | Conversio n promoting element | Conversio n agent | | | | |
| Comparative example 1 | 1 | Thermal plasma | CF₄ | N₂ | - | - | 14.53 | H₂O | 150 | 3,000 | - | 7,970 | - | 1.33 | 20 | 2,290 | 91.6 | 12.5 |
| Comparative example 2 | 1 | Thermal plasma | CF₄ | N₂ | - | - | 14.53 | H₂O | 150 | 3,000 | - | 12,000 | - | 2.00 | 980 | 1,680 | 42.0 | |
| Example 1 | 1 | Thermal plasma | CF₄ | N₂ | CsCl | Cs | 3.89 | H₂O | 150 | 3,000 | 100 | 12,000 | 0.008 | 2.00 | 980 | 1,680 | 99.5 | |
| Example 2 | 1 | Thermal plasma | CF₄ | N₂ | KNO₃ | K | 4.34 | H₂O | 150 | 3,000 | 100 | 12,000 | 0.008 | 2.00 | 980 | 1,680 | 99.2 | |
| Example 3 | 1 | Thermal plasma | CF₄ | N₂ | NaNO₃ | Na | 5.14 | H₂O | 150 | 3,000 | 100 | 12,000 | 0.008 | 2.00 | 980 | 1,680 | 98.0 | |
| Example 4 | 1 | Thermal plasma | CF₄ | N₂ | LiCl | Li | 5.39 | H₂O | 150 | 3,000 | 100 | 12,000 | 0.008 | 2.00 | 980 | 1,680 | 77.7 | |
| Example 5 | 1 | Thermal plasma | CF₄ | N₂ | CaCl₂ | Ca | 6.11 | H₂O | 150 | 3,000 | 100 | 12,000 | 0.008 | 2.00 | 980 | 1,680 | 55.0 | |
| Example 6 | 1 | Thermal plasma | CF₄ | N₂ | Cu(NO₃)₂ | Cu | 7.73 | H₂O | 150 | 3,000 | 100 | 12,000 | 0.008 | 2.00 | 980 | 1,680 | 48.6 | |
| Example 7 | 1 | Thermal plasma | CF₄ | N₂ | CoCl₂ | Co | 7.88 | H₂O | 150 | 3,000 | 100 | 12,000 | 0.008 | 2.00 | 980 | 1,680 | 47.8 | |
| Example 8 | 1 | Thermal plasma | CF₄ | N₂ | Zn(NO₃)₂ | Zn | 9.39 | H₂O | 150 | 3,000 | 100 | 12,000 | 0.008 | 2.00 | 980 | 1,680 | 45.0 | |

**Table 3**

| | FIG | Plasma generating means | Exhaust gas | | Conversion promoting agent | Conversion promoting element | 1st ionization energy (eV) | Conversion agent | Dilution gas flow rate (slpm) | Mole fraction (ppm) | | | Excess ratio | | T_{A} (°C) | T_{MIX} (°C) | Conversion (%) | Input Power (kW) |
|---|---|---|---|---|---|---|---|---|---|---|---|---|---|---|---|---|---|---|
| | | | Target gas | Dilutio n gas | | | | | | Target gas | Conversio n promoting element | Conversio n agent | Conversio n promoting element | Conversio n agent | | | | |
| Comparative example 3 | 1 | Thermal plasma | CF₄ | N₂ | - | - | 14.53 | H₂O | 150 | 3,000 | - | 7,970 | - | 1.33 | 900 | 1,610 | 44.5 | |
| Example 9 | 1 | Thermal plasma | CF₄ | N₂ | KOH | K | 4.34 | H₂O | 150 | 3,000 | 0.1 | 7,970 | 0.000 | 1.33 | 900 | 1,610 | 50.0 | |
| Example 10 | 1 | Thermal plasma | CF₄ | N₂ | KOH | K | 4.34 | H₂O | 150 | 3,000 | 1.1 | 7,970 | 0.000 | 1.33 | 900 | 1,610 | 55.3 | |
| Example 11 | 1 | Thermal | CF₄ | N₂ | KOH | K | 4.34 | H₂O | 150 | 3,000 | 11 | 7,970 | 0.001 | 1.33 | 900 | 1,610 | 73.1 | |
| | | plasma | | | | | | | | | | | | | | | | |
| Example 12 | 1 | Thermal plasma | CF₄ | N₂ | KOH | K | 4.34 | H₂O | 150 | 3,000 | 47 | 7,970 | 0.004 | 1.33 | 900 | 1,610 | 95.7 | |
| Example 13 | 1 | Thermal plasma | CF₄ | N₂ | KOH | K | 4.34 | H₂O | 150 | 3,000 | 90 | 7,970 | 0.008 | 1.33 | 900 | 1,610 | 99.2 | |
| Example 14 | 1 | Thermal plasma | CF₄ | N₂ | KOH | K | 4.34 | H₂O | 150 | 3,000 | 203 | 7,970 | 0.017 | 1.33 | 900 | 1,610 | 99.5 | |
| Comparative example 4 | 1 | Thermal plasma | CF₄ | N₂ | - | - | 14.53 | H₂O | 150 | 6,000 | - | 15,940 | - | 1.33 | 900 | 1,610 | 50.9 | |
| Example 15 | 1 | Thermal plasma | CF₄ | N₂ | KOH | K | 4.34 | H₂O | 150 | 6,000 | 0.2 | 15,940 | 0.000 | 1.33 | 900 | 1,610 | 52.0 | |
| Example 16 | 1 | Thermal plasma | CF₄ | N₂ | KOH | K | 4.34 | H₂O | 150 | 6,000 | 2.2 | 15,940 | 0.000 | 1.33 | 900 | 1,610 | 56.4 | |
| Example 17 | 1 | Thermal plasma | CF₄ | N₂ | KOH | K | 4.34 | H₂O | 150 | 6,000 | 22 | 15,940 | 0.001 | 1.33 | 900 | 1,610 | 77.2 | |
| Example 18 | 1 | Thermal plasma | CF₄ | N₂ | KOH | K | 4.34 | H₂O | 150 | 6,000 | 93 | 15,940 | 0.004 | 1.33 | 900 | 1,610 | 94.1 | |
| Example 19 | 1 | Thermal plasma | CF₄ | N₂ | KOH | K | 4.34 | H₂O | 150 | 6,000 | 195 | 15,940 | 0.008 | 1.33 | 900 | 1,610 | 96.2 | |
| Example 20 | 1 | Thermal plasma | CF₄ | N₂ | KOH | K | 4.34 | H₂O | 150 | 6,000 | 368 | 15,940 | 0.015 | 1.33 | 900 | 1,610 | 96.5 | |
| Comparative example 5 | 1 | Thermal plasma | CF₄ | N₂ | - | - | 14.53 | H₂O | 150 | 9,000 | - | 23,910 | - | 1.33 | 900 | 1,610 | 49.5 | |
| Example 21 | 1 | Thermal plasma | CF₄ | N₂ | KOH | K | 4.34 | H₂O | 150 | 9,000 | 0.3 | 23,910 | 0.000 | 1.33 | 900 | 1,610 | 50.1 | |
| Example 22 | 1 | Thermal plasma | CF₄ | N₂ | KOH | K | 4.34 | H₂O | 150 | 9,000 | 3.2 | 23,910 | 0.000 | 1.33 | 900 | 1,610 | 55.3 | |
| Example 23 | 1 | Thermal plasma | CF₄ | N₂ | KOH | K | 4.34 | H₂O | 150 | 9,000 | 33 | 23,910 | 0.001 | 1.33 | 900 | 1,610 | 73.6 | |
| Example 24 | 1 | Thermal plasma | CF₄ | N₂ | KOH | K | 4.34 | H₂O | 150 | 9,000 | 147 | 23,910 | 0.004 | 1.33 | 900 | 1,610 | 84.0 | |
| Example 25 | 1 | Thermal plasma | CF₄ | N₂ | KOH | K | 4.34 | H₂O | 150 | 9,000 | 281 | 23,910 | 0.008 | 1.33 | 900 | 1,610 | 87.2 | |
| Example 26 | 1 | Thermal plasma | CF₄ | N₂ | KOH | K | 4.34 | H₂O | 150 | 9,000 | 562 | 23,910 | 0.016 | 1.33 | 900 | 1,610 | 87.2 | |

**Table 4**

| | FIG | Plasma generating means | Exhaust gas | | Conversion promoting agent | Conversion promoting element | 1st ionization energy (eV) | Conversion agent | Dilution gas flow rate (slpm) | Mole fraction (ppm) | | | Excess ratio | | T_{A} (°C) | T_{MIX} (°C) | Conversion (%) | Input Power (kW) |
|---|---|---|---|---|---|---|---|---|---|---|---|---|---|---|---|---|---|---|
| | | | Target gas | Dilution gas | | | | | | Target gas | Conversio n promoting element | Conversio n agent | Conversio n promoting element | Conversio n agent | | | | |
| Example 27 | 1 | Thermal plasma | CF₄ | N₂ | KOH | K | 4.34 | H₂O | 150 | 3,000 | 100 | 870 | 0.008 | 0.15 | 880 | 1,590 | 36.1 | |
| Example 28 | 1 | Thermal | CF₄ | N₂ | KOH | K | 4.34 | H₂O | 150 | 3,000 | 100 | 1,800 | 0.008 | 0.30 | 880 | 1,590 | 47.5 | |
| | | plasma | | | | | | | | | | | | | | | | |
| Example 29 | 1 | Thermal plasma | CF₄ | N₂ | KOH | K | 4.34 | H₂O | 150 | 3,000 | 100 | 2,380 | 0.008 | 0.40 | 880 | 1,590 | 54.2 | |
| Example 30 | 1 | Thermal plasma | CF₄ | N₂ | KOH | K | 4.34 | H₂O | 150 | 3,000 | 100 | 3,600 | 0.008 | 0.60 | 880 | 1,590 | 70.3 | |
| Example 31 | 1 | Thermal plasma | CF₄ | N₂ | KOH | K | 4.34 | H₂O | 150 | 3,000 | 100 | 4,800 | 0.008 | 0.80 | 880 | 1,590 | 81.8 | |
| Example 32 | 1 | Thermal plasma | CF₄ | N₂ | KOH | K | 4.34 | H₂O | 150 | 3,000 | 100 | 6,000 | 0.008 | 1.00 | 880 | 1,590 | 94.7 | |
| Example 33 | 1 | Thermal plasma | CF₄ | N₂ | KOH | K | 4.34 | H₂O | 150 | 3,000 | 100 | 7,200 | 0.008 | 1.20 | 880 | 1,590 | 99.6 | 4.4 |
| Example 34 | 1 | Thermal plasma | CF₄ | N₂ | KOH | K | 4.34 | H₂O | 150 | 3,000 | 100 | 9,100 | 0.008 | 1.52 | 880 | 1,590 | 99.4 | |
| Example 35 | 1 | Thermal plasma | CF₄ | N₂ | KOH | K | 4.34 | H₂O | 150 | 3,000 | 100 | 12,000 | 0.008 | 2.00 | 880 | 1,590 | 98.5 | |
| Example 36 | 1 | Thermal plasma | CF₄ | N₂ | KOH | K | 4.34 | H₂O | 150 | 3,000 | 100 | 18,000 | 0.008 | 3.00 | 880 | 1,590 | 94.0 | |
| Example 37 | 1 | Thermal plasma | CF₄ | N₂ | KOH | K | 4.34 | H₂O | 150 | 3,000 | 100 | 24,000 | 0.008 | 4.00 | 880 | 1,590 | 91.9 | |
| Comparative example 6 | 2 | Thermal plasma | CF₄ | N₂ | - | - | 14.53 | H₂O | 150 | 3,000 | - | 7,500 | - | 1.25 | 710 | 1,550 | 42.0 | |
| Comparative example 7 | 2 | Thermal plasma | CF₄ | N₂ | - | - | 14.53 | - | 150 | 3,000 | - | - | - | - | 710 | 1,550 | 9.5 | |
| Comparative example 8 | 2 | Thermal plasma | CF₄ | N₂ | K | K | 4.34 | - | 150 | 3,000 | 170 | - | - | 0.01 | 710 | 1,550 | 18.1 | |
| Comparative example 9 | 2 | Thermal plasma | CF₄ | N₂ | K | K | 4.34 | - | 150 | 3,000 | 340 | - | - | 0.03 | 710 | 1,550 | 20.0 | |
| Comparative example 10 | 2 | Thermal plasma | CF₄ | N₂ | K | K | 4.34 | - | 150 | 3,000 | 500 | - | - | 0.04 | 710 | 1,550 | 23.6 | |
| Comparative example 11 | 2 | Thermal plasma | CF₄ | N₂ | K | K | 4.34 | - | 150 | 3,000 | 790 | - | - | 0.07 | 710 | 1,550 | 27.3 | |
| Example 38 | 2 | Thermal plasma | CF₄ | N₂ | K | K | 4.34 | H₂O | 150 | 3,000 | 170 | 7,500 | 0.014 | 1.25 | 710 | 1,550 | 99.2 | |
| Example 39 | 2 | Thermal plasma | CF₄ | N₂ | K | K | 4.34 | H₂O | 150 | 3,000 | 790 | 7,500 | 0.066 | 1.25 | 710 | 1,550 | 99.5 | |

**Table 5**

| | FIG | Plasma generating means | Exhaust gas | | Conversion promoting agent | Conversion promoting element | 1st ionization energy (eV) | Conversion agent | Dilution gas flow rate (slpm) | Mole fraction (ppm) | | | Excess ratio | | T_{A} (°C) | T_{MIX} (°C) | Conversion (%) | Input Power (kW) |
|---|---|---|---|---|---|---|---|---|---|---|---|---|---|---|---|---|---|---|
| | | | Target gas | Dilution gas | | | | | | Target gas | Conversio n promoting element | Conversio n agent | Conversio n promoting element | Conversio n agent | | | | |
| Comparative example 12 | 1 | Thermal plasma | CF₄ | N₂ | - | - | 14.53 | H₂O | 150 | 3,000 | - | 12,000 | - | 2.00 | 960 | 1,650 | 42.3 | |
| Example 40 | 1 | Thermal | CF₄ | N₂ | KOH | K | 4.34 | H₂O | 150 | 3,000 | 100 | 12,000 | 0.008 | 2.00 | 960 | 1,650 | 99.3 | |
| | | plasma | | | | | | | | | | | | | | | | |
| Example 41 | 1 | Thermal plasma | CF₄ | N₂ | KNO₃ | K | 4.34 | H₂O | 150 | 3,000 | 100 | 12,000 | 0.008 | 2.00 | 960 | 1,650 | 98.1 | |
| Example 42 | 1 | Thermal plasma | CF₄ | N₂ | K₂CO₃ | K | 4.34 | H₂O | 150 | 3,000 | 100 | 12,000 | 0.008 | 2.00 | 960 | 1,650 | 99.2 | |
| Example 43 | 1 | Thermal plasma | CF₄ | N2 | KHCO₃ | K | 4.34 | H₂O | 150 | 3,000 | 100 | 12,000 | 0.008 | 2.00 | 960 | 1,650 | 98.5 | |
| Example 44 | 1 | Thermal plasma | CF₄ | N₂ | KF | K | 4.34 | H₂O | 150 | 3,000 | 100 | 12,000 | 0.008 | 2.00 | 960 | 1,650 | 94.0 | |
| Example 45 | 1 | Thermal plasma | CF₄ | N₂ | KCl | K | 4.34 | H₂O | 150 | 3,000 | 100 | 12,000 | 0.008 | 2.00 | 960 | 1,650 | 95.2 | |
| Example 46 | 1 | Thermal plasma | CF₄ | N₂ | KBr | K | 4.34 | H₂O | 150 | 3000 | 100 | 12,000 | 0.008 | 2.00 | 960 | 1,650 | 98.4 | |
| Example 47 | 1 | Thermal plasma | CF₄ | N₂ | CH₃COOK | K | 4.34 | H₂O | 150 | 3000 | 100 | 12,000 | 0.008 | 2.00 | 960 | 1,650 | 97.7 | |
| Example 48 | 1 | Thermal plasma | CF₄ | N₂ | K₂HPO₄ | K | 4.34 | H₂O | 150 | 3000 | 100 | 12,000 | 0.008 | 2.00 | 960 | 1,650 | 90.8 | |
| Comparative example 13 | 1 | Thermal plasma | CF₄ | N₂ | - | - | 14.53 | H₂ | 150 | 3000 | - | 7,500 | - | 1.25 | 970 | 1,630 | 44.5 | |
| Comparative example 14 | 1 | Thermal plasma | CF₄ | N₂ | - | - | 14.53 | H₂/H₂O | 150 | 3000 | - | 6,000/972 | - | 1.00/0.16 | 970 | 1,630 | 50.1 | |
| Example 49 | 1 | Thermal plasma | CF₄ | N₂ | KOH | K | 4.34 | H₂/H₂O | 150 | 3000 | 166 | 6,000/972 | 0.014 | 1.00/0.16 | 970 | 1,630 | 99.3 | |
| Comparative example 15 | 1 | Thermal plasma | CF₄ | N₂ | - | - | 14.53 | H₂O | 150 | 3000 | - | 12,000 | - | 2.00 | 348 | 1,146 | 18.6 | |
| Comparative example 16 | 1 | Thermal plasma | CF₄ | N₂ | - | - | 14.53 | H₂O | 150 | 3,000 | - | 12,000 | - | 2.00 | 508 | 1,266 | 21.3 | |
| Comparative example 17 | 1 | Thermal plasma | CF₄ | N₂ | - | - | 14.53 | H₂O | 150 | 3,000 | - | 12,000 | - | 2.00 | 609 | 1,345 | 27.4 | |
| Comparative example 18 | 1 | Thermal plasma | CF₄ | N₂ | - | - | 14.53 | H₂O | 150 | 3,000 | - | 12,000 | - | 2.00 | 715 | 1,426 | 33.4 | |
| Comparative example 19 | 1 | Thermal plasma | CF₄ | N₂ | - | - | 14.53 | H₂O | 150 | 3,000 | - | 12,000 | - | 2.00 | 817 | 1,489 | 39.9 | |
| Comparative example 20 | 1 | Thermal plasma | CF₄ | N₂ | - | - | 14.53 | H₂O | 150 | 3,000 | - | 12,000 | - | 2.00 | 834 | 1,524 | 41.6 | |
| Example 50 | 1 | Thermal plasma | CF₄ | N₂ | KOH | K | 4.34 | H₂O | 150 | 3,000 | 100 | 12,000 | 0.008 | 2.00 | 630 | 1,119 | 35.2 | |
| Example 51 | 1 | Thermal plasma | CF₄ | N₂ | KOH | K | 4.34 | H₂O | 150 | 3,000 | 100 | 12,000 | 0.008 | 2.00 | 650 | 1,203 | 53.9 | |
| Example 52 | 1 | Thermal plasma | CF₄ | N₂ | KOH | K | 4.34 | H₂O | 150 | 3,000 | 100 | 12,000 | 0.008 | 2.00 | 720 | 1,325 | 73.2 | |
| Example 53 | 1 | Thermal plasma | CF₄ | N₂ | KOH | K | 4.34 | H₂O | 150 | 3,000 | 100 | 12,000 | 0.008 | 2.00 | 800 | 1,461 | 91.3 | |
| Example 54 | 1 | Thermal plasma | CF₄ | N₂ | KOH | K | 4.34 | H₂O | 150 | 3,000 | 100 | 12,000 | 0.008 | 2.00 | 840 | 1,525 | 97.0 | |
| Example 55 | 1 | Thermal plasma | CF₄ | N₂ | KOH | K | 4.34 | H₂O | 150 | 3,000 | 100 | 12,000 | 0.008 | 2.00 | 890 | 1,549 | 98.7 | |

**Table 6**

| | FIG | Plasma generating means | Exhaust gas | | Conversion promoting agent | Conversion promoting element | 1st ionization energy (eV) | Conversion agent | Dilution gas flow rate (slpm) | Mole fraction (ppm) | | | Excess ratio | | T_{A} (°C) | T_{MIX} (°C) | Conversion (%) | Input Power (kW) |
|---|---|---|---|---|---|---|---|---|---|---|---|---|---|---|---|---|---|---|
| | | | Target gas | Dilutio n gas | | | | | | Target gas | Conversio n promoting element | Conversio n agent | Conversio n promoting element | Conversio n agent | | | | |
| Example 56 | 3 | Thermal plasma | CF₄ | N₂ | KNO₃ | K | 4.34 | H₂O | 150 | 3,000 | 68 | 10,050 | 0.006 | 1.68 | 930 | 1,550 | 97.4 | |
| Example 57 | 3 | Thermal plasma | CF₄ | N₂ | KNO₃ | K | 4.34 | H₂O | 300 | 3,000 | 68 | 10,050 | 0.006 | 1.75 | 950 | 1,570 | 98.7 | |
| Example 58 | 3 | Thermal plasma | CF₄ | N₂ | KNO₃ | K | 4.34 | H₂O | 600 | 3,000 | 68 | 9,900 | 0.006 | 1.65 | 900 | 1,550 | 99.2 | |
| Example 59 | 4 | Thermal plasma | CF₄ | N₂ | KNO₃ | K | 4.34 | H₂O | 150 | 3,000 | 63 | 7,500 | 0.005 | 1.25 | 920 | 1,570 | 97.2 | |
| Comparative example 21 | 1 | Thermal plasma | C₂F₆ | N₂ | - | - | 14.53 | H₂O | 200 | 3,000 | - | 7,900 | - | 1.32 | 520 | 1,050 | 63.4 | |
| Example 60 | 1 | Thermal plasma | C₂F₆ | N₂ | KOH | K | 4.34 | H₂O | 200 | 3,000 | 100 | 7,900 | 0.008 | 1.32 | 520 | 1,050 | 99.0 | |
| Comparative example 22 | 1 | Thermal plasma | SF₆ | N₂ | - | - | 14.53 | H₂O | 200 | 3,000 | - | 7,450 | - | 1.24 | 630 | 1,130 | 68.0 | |
| Example 61 | 1 | Thermal plasma | SF₆ | N₂ | KOH | K | 4.34 | H₂O | 200 | 3,000 | 140 | 7,450 | 0.012 | 1.24 | 630 | 1,130 | 98.2 | |
| Comparative example 23 | | Combustion burner | CF₄ | N₂ | - | - | 14.53 | C₃H₈, O₂ | 100 | 2,900 | - | - | - | ∼6 | 20 | N/A | 39.5 | |
| Example 62 | | Combustion burner | CF₄ | N₂ | KOH | K | 4.34 | C₃H₈,O₂ | 100 | 2,900 | 240 | - | 0.021 | ∼6 | 20 | N/A | 68.2 | |
| Comparative example 24 | | Gliding arc | CF₄ | N₂ | - | - | 14.53 | H₂O | 30 | 3,000 | - | 8,400 | - | 1.40 | 20 | N/A | 46.0 | |
| Example 63 | | Gliding arc | CF₄ | N₂ | NaOH | Na | 5.14 | H₂O | 30 | 3,000 | 190 | 8,400 | 0.016 | 1.40 | 20 | N/A | 60.5 | |
| Comparative example 25 | | Electric heater | CF₄ | N₂ | - | - | 14.53 | H₂O | 60 | 3,200 | - | 19,850 | - | 3.10 | 20 | 1,130 | 21.4 | |
| Example 64 | | Electric heater | CF₄ | N₂ | KOH | K | 4.34 | H₂O | 60 | 3,200 | 450 | 18,460 | 0.035 | 2.88 | 20 | 1,130 | 55.3 | |
| Example 65 | | Electric heater | CF₄ | N₂ | KOH | K | 4.34 | H₂O | 60 | 3,200 | 2,250 | 12,900 | 0.176 | 2.02 | 20 | 1,130 | 98.7 | |
| Comparative example 26 | | Electric heater | NF₃ | N₂ | - | - | 14.53 | H₂O | 60 | 3,200 | - | 19,850 | - | 4.14 | 20 | 800 | 92.5 | |
| Example 66 | | Electric heater | NF₃ | N₂ | KOH | K | 4.34 | H₂O | 60 | 3,200 | 450 | 18,460 | 0.035 | 3.85 | 20 | 800 | 97.9 | |

Comparative example 2 and examples 1 to 8 show that adding the conversion promoting element increases the conversion of CF₄, and the lower the first ionization energy of the conversion promoting element, the greater the effect of conversion increase. The very low mole fraction of the conversion promoting element compared to that of target gas and the excess ratio of the conversion promoting element much lower than 1 implies that the conversion promoting element acts as a kind of catalyst. The excess ratio of 2 of the conversion agent means that the twice the amount required for conversion is sufficiently supplied. Where the conversion promoting element is not added, the first ionization energy of nitrogen is indicated. FIG. 5 shows the conversions of CF₄ depending on the first ionization energy of the conversion promoting element.

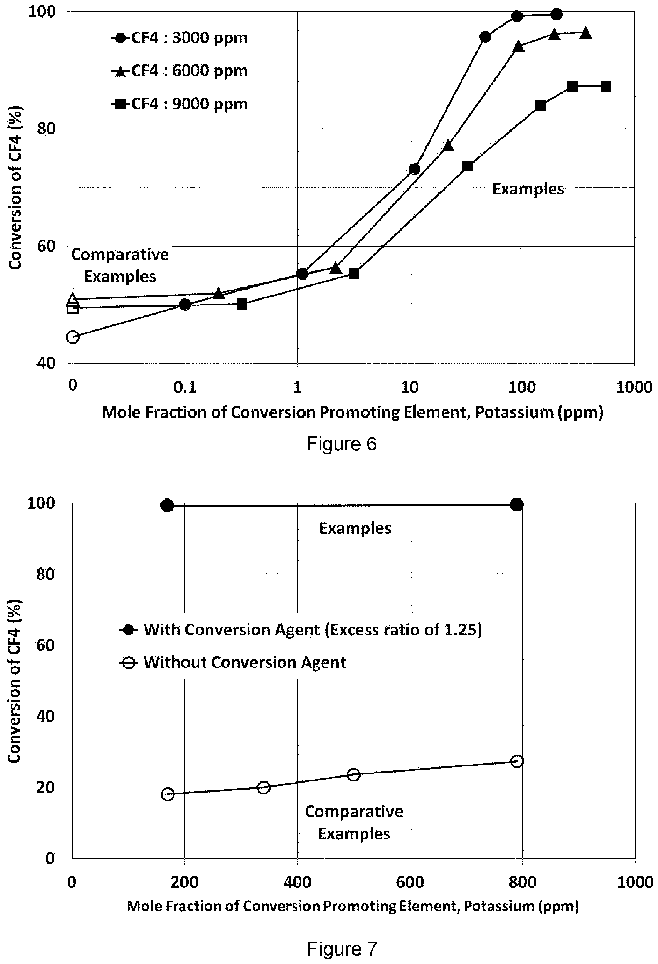

Comparative examples 3 to 5 and examples 9 to 26 show that the conversion promoting element is effective from very low mole fraction of 0.1 ppm, and the conversion of CF₄ is increased as the mole fraction of the conversion promoting element increases. As the mole fraction of CF₄ increases, the mole fraction of the conversion promoting element must also increase to achieve the same conversion. This is expected because fluorine in CF₄ has a high electron affinity and has a strong tendency to trap electrons and become negative ions, thereby consuming electrons generated by conversion promoting elements. Even in this case, the excess ratio of the conversion promoting element is still much less than 1. FIG. 6 shows the conversions of CF₄ depending on the mole fraction of the conversion promoting element, potassium. Since FIG. 6 shows the result at fixed input power, it is only required to slightly increase the power supplied to the DC thermal plasma torch to further increase the conversion in case the mole fraction of CF₄ is high.

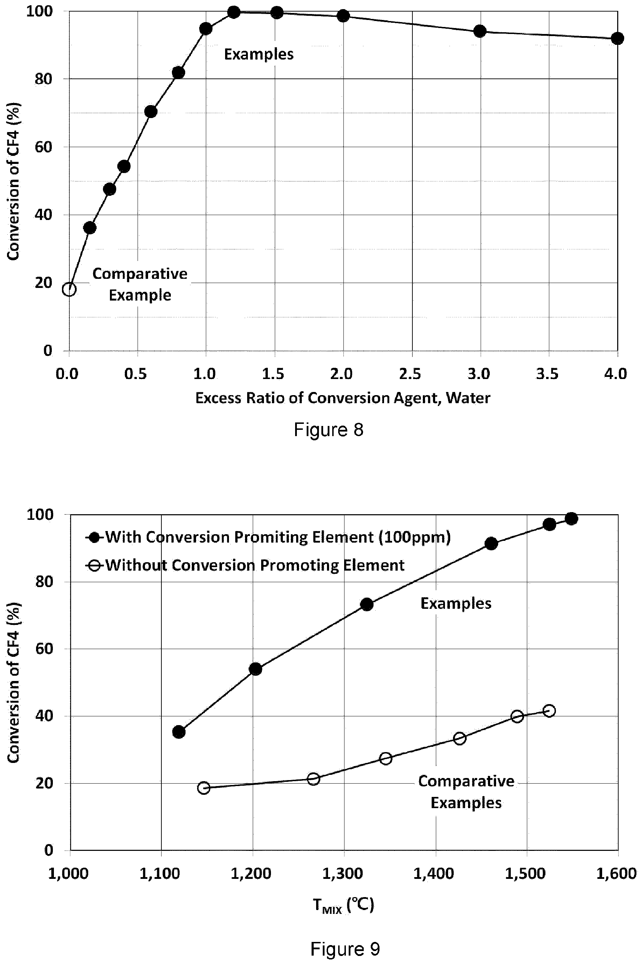

Examples 27 to 39 and comparative examples 6 to 11 show that in the absence of a conversion agent, the conversion promoting element does not play the role of conversion promotion, but plays the role of the conversion agent to result in difficulty in achieving a high conversion. When adding a conversion agent, it is preferable to ensure that the excess ratio is at least 1. FIG. 7 shows the conversions of CF₄ depending on the presence of the conversion agent, water. FIG. 8 shows the conversions of CF₄ depending on the excess ratio of the conversion agent, water.

Comparative example 12 and examples 40 to 48 show the cases of using several types of compounds as the conversion promoting agent. It can be seen that almost the same high conversion can be achieved no matter which compound is used.

Comparative examples 13 and 14, and example 49 show that high conversion can also be obtained when hydrogen is used as the conversion agent. In this case, a small amount of water was added due to the use of aqueous solution as a feedstock for the conversion promoting element.

Comparative examples 15 to 20, and examples 50 to 55 show that the addition of the conversion promoting element can lower the temperature required for the conversion of the target gas, and preheating the exhaust gas containing the target gas increases the effectiveness of the conversion promoting element further. FIG. 9 shows the conversions of CF₄ depending on the presence of the conversion promoting element and T_{MIX}.

Examples 56 to 58 show that the present disclosure is also very effective for a large amount of the exhaust gas containing target gas. Example 59 shows that it is possible to supply conversion promoting elements easily without any quantitative feeding device or separate vaporization heat sources. Comparative examples 21, 22 and 26, and examples 60, 61 and 66 show that the present disclosure is also applicable to other target gas than CF₄.

Comparative example 1 and examples 33 show that the present disclosure contributes to significant energy savings.

Comparative examples 23 to 26, and examples 62 to 66 show the effects of the present disclosure can be achieved for other plasmas than thermal plasma. The combustion burner used 2.0 slpm of LPG as a fuel and 12.4 slpm of oxygen as an oxidizer. For gliding arcs, a voltage of 50 kHz, 5 us, and 7.2 kV was applied.

The present disclosure can be summarized as follows.

The method for converting the target gas contained in the exhaust gas in plasma phase comprises the steps of: generating a plasma in a conversion region in which the conversion of the target gas occurs; supplying, to the conversion region, a conversion promoting agent containing a conversion promoting element of which the first ionization energy is not greater than 10eV for promoting the conversion of the target gas; supplying, to the conversion region, a conversion agent that produces conversion products by combining with the dissociation products of the target gas and prevents the dissociation products from recombining into the target gas; and supplying the exhaust gas containing the target gas to the conversion region.

The excess ratio of the conversion promoting element can be 1 or smaller.

The excess ratio of the conversion agent can be 1 or greater.

The mole fraction of the conversion promoting element in the conversion region can ranges between 0.1 and 10,000 ppm.

The mole fraction of the conversion promoting element in the conversion region can ranges between 0.1 and 10,000 ppm.

The conversion promoting element can be at least one selected from a group composed of alkali metals and alkaline earth metals.

The conversion promoting element can be at least one selected from lithium, sodium, potassium and cesium.

The conversion promoting agent can be at least one selected from a group composed of metals, compounds, alloys, intermetallic compounds and minerals.

The compound can be at least one selected from a group composed of hydroxide, nitrate, nitrite, carbonate, hydrogen carbonate, percarbonate, acetate, formate, fluoride, chloride, chlorate, chlorite, hypochlorite, bromide, borohydride, phosphate, phosphite, hypophosphite, phthalate, sulfate, sulfide, dithionite, sulfamate, oxalate, oxide, and isopropoxide.

The conversion agent can contain at least one selected from hydrogen, oxygen, nitrogen and carbon as a constituent element.

The conversion agent can be at least one selected from a group composed of water, hydrogen, oxygen and hydrocarbons.

A solution in which the conversion promoting agent is dissolved in the liquid phase conversion agent can be used as a feedstock.

The liquid phase conversion agent can be water.

The method can further comprise a step of preheating the exhaust gas containing the target gas before supplying it to the conversion region.

The preheating can be achieved by recovering waste heat remaining in the material after passing through the conversion region with heat exchange.

The target gas can be at least one selected from a group composed of halogen compounds.

The target gas can be at least one selected from a group composed of perfluorocompounds, hydrofluorocarbons, chlorofluorocarbons, hydrochlorofluorocarbons, SF₆ and NF₃.

The target gas can be at least one selected from CF₄, C₂F₆, CHF₃, C₃F₈, C₄F₆, C₄F₈, NF₃ and SF₆.

The plasma can be thermal plasma, combustion flame, non-equilibrium plasma, heated gas, or a mixture thereof.

An apparatus for converting the target gas contained in the exhaust gas in plasma phase, comprises: a body comprising a conversion region in which the conversion of the target gas occurs; a plasma generating means for generating plasma in the conversion region; a means for supplying, to the conversion region, a conversion promoting agent containing a conversion promoting element of which the first ionization energy is not greater than 10eV for promoting the conversion of the target gas; a means for supplying, to the conversion region, a conversion agent that produces conversion products by combining with the dissociation products of the target gas and prevents the dissociation products from recombining into the target gas; and a means for supplying the exhaust gas containing the target gas to the conversion region.

The mole fraction of the conversion promoting element in the conversion region can range between 0.1 and 10,000 ppm.

The apparatus can further comprise a heat exchanger for recovering waste heat remaining in the material after passing through the conversion region to preheat the exhaust gas containing the target gas before supplying it to the conversion region.

The apparatus can use a solution in which the conversion promoting agent is dissolved in the liquid phase conversion agent as a feedstock.

The apparatus can vaporize at least one of the conversion promoting agent and the conversion agent directly with the heat of the conversion region.

The apparatus can further comprise a means for vaporizing at least one of the conversion promoting agent and the conversion agent before supplying it to the conversion region.

The apparatus can supply at least one of the conversion promoting agent and the conversion agent to the conversion region after passing it through a high-temperature region in the plasma generating means.

The apparatus can further comprise a means for making an aerosol of at least one of the conversion promoting agent and the conversion agent.

The means for making an aerosol can be an atomizer.

The atomizer can have a separating part with inclined surface at its exit.

The outside of the atomizer can be cooled by a coolant.

The conversion promoting agent can be precharged in a vaporization part and the feed rate to the conversion region can be controlled by means of the temperature of the conversion promoting agent and flow rate of the carrier gas.

The plasma generating means can be at least one selected from a group composed of a thermal plasma generating means, a combustion burner, a non-equilibrium plasma generating means, and an electric heater.

Thermal plasmas generating means can be a DC thermal plasma torch.

The explanation as set forth above is merely described as a technical idea of the exemplary embodiments of the present disclosure, and it will be readily understood by those skilled in the art to which this present disclosure belongs that various changes and modifications may be made without departing from the scope of the characteristics of the embodiments of the present disclosure. Therefore, the exemplary embodiments disclosed herein are not used to limit the technical idea of the present disclosure, but to explain the present disclosure, and the scope of the technical idea of the present disclosure is not limited to these embodiments. Therefore, the scope of protection of the present disclosure should be construed as defined in the following claims and changes, modifications and equivalents that fall within the technical idea of the present disclosure are intended to be embraced by the scope of the claims of the present disclosure.

### DESCRIPTION OF NUMERALS

- A :: exhaust gas containing target gas
- M :: conversion promoting element
- M1 :: conversion promoting agent
- M2 :: quantitative feeding device
- M10 :: atomizer
- M11 :: atomizing gas
- M12 :: gap
- M13 :: separating part
- M14 :: coolant
- M20 :: vaporization part
- M21 :: carrier gas
- M22 :: thermocouple
- M23 :: feed port for the conversion promoting element
- M24 :: external vaporizing heat source
- N :: conversion agent
- N2 :: quantitative feeding device
- P :: plasma jet
- R :: conversion region
- 10 :: conversion apparatus
- 20 :: body
- 21 :: feed port for the exhaust gas containing the target gas
- 22 :: feed port for the conversion agent
- 30 :: heat exchanger
- 31 :: blocking wall
- 32 :: swirling flow generating mechanism
- 35 :: guide
- 36 :: thermocouple
- 40 :: DC thermal plasma torch
- 43 :: plasma forming gas
- 45 :: material after passing through the conversion region
- 50 :: water tank
- 60 :: wet scrubber
- 61 :: spray nozzle
- 62 :: packing media
- 63 :: exhaust port

## Claims

1. A method for converting the target gas contained in the exhaust gas in plasma phase, comprising the steps of:
generating a plasma in a conversion region in which the conversion of the target gas occurs;
supplying, to the conversion region, a conversion promoting agent containing a conversion promoting element of which the first ionization energy is not greater than 10eV for promoting the conversion of the target gas;
supplying, to the conversion region, a conversion agent that produces conversion products by combining with the dissociation products of the target gas and prevents the dissociation products from recombining into the target gas; and
supplying the exhaust gas containing the target gas to the conversion region.

2. The method of claim 1, wherein the excess ratio of the conversion promoting element is 1 or smaller.

3. The method of claim 1, wherein the excess ratio of the conversion agent is 1 or greater.

4. The method of claim 1, wherein the mole fraction of the conversion promoting element in the conversion region ranges between 0.1 and 10,000 ppm.

5. The method of claim 1, wherein the mole fraction of the conversion promoting element in the conversion region ranges between 1 and 1,000 ppm.

6. The method of claim 1, wherein the conversion promoting element is at least one selected from a group composed of alkali metals and alkaline earth metals.

7. The method of claim 1, wherein the conversion promoting element is at least one selected from lithium, sodium, potassium and cesium.

8. The method of claim 1, wherein the conversion promoting agent is at least one selected from a group composed of metals, compounds, alloys, intermetallic compounds and minerals.

9. The method of claim 8, wherein the compound is at least one selected from a group composed of hydroxide, nitrate, nitrite, carbonate, hydrogen carbonate, percarbonate, acetate, formate, fluoride, chloride, chlorate, chlorite, hypochlorite, bromide, borohydride, phosphate, phosphite, hypophosphite, phthalate, sulfate, sulfide, dithionite, sulfamate, oxalate, oxide, and isopropoxide.

10. The method of claim 1, wherein the conversion agent contains at least one selected from hydrogen, oxygen, nitrogen and carbon as a constituent element.

11. The method of claim 1, wherein the conversion agent is at least one selected from a group composed of water, hydrogen, oxygen and hydrocarbons.

12. The method of claim 1, wherein a solution in which the conversion promoting agent is dissolved in the liquid phase conversion agent is used as a feedstock.

13. The method of claim 12, wherein the liquid phase conversion agent is water.

14. The method of claim 1, further comprising a step of preheating the exhaust gas containing the target gas before supplying it to the conversion region.

15. The method of claim 14, wherein the preheating is achieved by recovering waste heat remaining in the material after passing through the conversion region with heat exchange.

16. The method of claim 1, wherein the target gas is at least one selected from a group composed of halogen compounds.

17. The method of claim 1, wherein the target gas is at least one selected from a group composed of perfluorocompounds, hydrofluorocarbons, chlorofluorocarbons, hydrochlorofluorocarbons, SF₆ and NF₃.

18. The method of claim 1, wherein the target gas is at least one selected from CF₄, C₂F₆, CHF₃, C₃F₈, C₄F₆, C₄F₈, NF₃ and SF₆.

19. The method of claim 1, wherein the plasma is one of thermal plasma, combustion flame, non-equilibrium plasma, and heated gas, or a mixture thereof.

20. An apparatus for converting the target gas contained in the exhaust gas in plasma phase, comprising:
a body comprising a conversion region in which the conversion of the target gas occurs;
a plasma generating means for generating plasma in the conversion region;
a means for supplying, to the conversion region, a conversion promoting agent containing a conversion promoting element of which the first ionization energy is not greater than 10eV for promoting the conversion of the target gas;
a means for supplying, to the conversion region, a conversion agent that produces conversion products by combining with the dissociation products of the target gas and prevents the dissociation products from recombining into the target gas; and
a means for supplying the exhaust gas containing the target gas to the conversion region.

21. The apparatus of claim 20, wherein the mole fraction of the conversion promoting element in the conversion region ranges between 0.1 and 10,000 ppm.

22. The apparatus of claim 20, further comprising a heat exchanger for recovering waste heat remaining in the material after passing through the conversion region to preheat the exhaust gas containing the target gas before supplying it to the conversion region.

23. The apparatus of claim 20, wherein a solution in which the conversion promoting agent is dissolved in the liquid phase conversion agent is used as a feedstock.

24. The apparatus of claim 20, wherein at least one of the conversion promoting agent and the conversion agent is vaporized directly with the heat of the conversion region.

25. The apparatus of claim 20, further comprising a means for vaporizing at least one of the conversion promoting agent and the conversion agent before supplying it to the conversion region.

26. The apparatus of claim 20, wherein at least one of the conversion promoting agent and the conversion agent is supplied to the conversion region after passing it through a high-temperature region in the plasma generating means.

27. The apparatus of claims from 24 to 26, further comprising a means for making an aerosol of at least one of the conversion promoting agent and the conversion agent.

28. The apparatus of claim 27, wherein the means for making an aerosol is an atomizer.

29. The apparatus of claim 28, wherein the atomizer has a separating part with inclined surface at its exit.

30. The apparatus of claim 28, wherein the outside of the atomizer is cooled by a coolant.

31. The apparatus of claim 20, wherein the conversion promoting agent is precharged in a vaporization part and the feed rate to the conversion region is controlled by means of the temperature of the conversion promoting agent and flow rate of the carrier gas.

32. The apparatus of claim 20, wherein the plasma generating means is at least one selected from a group composed of a thermal plasma generating means, a combustion burner, a non-equilibrium plasma generating means, and an electric heater.

33. The apparatus of claim 32, wherein the thermal plasma generating means is a DC thermal plasma torch.
